# EUROPÄISCHE PATENTSCHRIFT

(11) **EP 1 532 689 B1**
(45) Veröffentlichungstag und Bekanntmachung des Hinweises auf die Patenterteilung: **17.03.2010**
(21) Anmeldenummer: 03790703.7
(22) Anmeldetag: 08.08.2003
(51) Int. Cl.: H01L 29/792, H01L 21/336, G11C 11/56

(54) **NICHTFLÜCHTIGES HALBLEITERSPEICHERELEMENT SOWIE ZUGEHÖRIGES HERSTELLUNGS- UND ANSTEUERVERFAHREN**
NON-VOLATILE SEMICONDUCTOR MEMORY ELEMENT AND CORRESPONDING PRODUCTION AND OPERATION METHOD
ELEMENT SEMI-CONDUCTEUR DE MEMOIRE NON VOLATILE ET PROCEDE DE REALISATION ET PROCEDE DE COMMANDE CORRESPONDANTS

(30) Priorität: 23.08.2002 DE 10238784
(43) Veröffentlichungstag der Anmeldung: 25.05.2005
(73) Patentinhaber: Infineon Technologies AG, 85579 Neubiberg (DE)
(72) Erfinder: SCHULER, Franz, 85586 Poing (DE); TEMPEL, Georg, 01099 Dresden (DE)
(74) Vertreter: Kindermann, Peter
(86) Internationale Anmeldenummer: PCT/DE2003/002678
(87) Internationale Veröffentlichungsnummer: WO 2004/021448

(56) Entgegenhaltungen:
- EP-A- 0 543 703
- WO-A-01/17030
- US-A- 3 731 163
- US-A- 5 654 568
- US-A1- 2002 105 023
- US-B1- 6 249 022
- US-B1- 6 335 554
- US-B1- 6 366 500
- US-B1- 6 388 293

## Beschreibung

Die vorliegende Erfindung bezieht sich auf ein nichtflüchtiges Halbleiterspeicherelement sowie ein zugehöriges Herstellungs- und Ansteuerverfahren und insbesondere auf eine nichtflüchtige Dual-Bit Split-Gate-Speicherzelle, bei der ein Einschreiben von Informationen mittels sourceseitiger Ladungsträgerinjektion erfolgt.

Nichtflüchtige Halbleiterspeicher, wie sie beispielsweise als FLASH-Speicher, EPROM, EEPROM, FPGAs und dergleichen bekannt sind, setzen sich in vielen Bereichen wie z.B. der Datenverarbeitungstechnik, der Telekömmunikationstechnik, der Unterhaltungselektronik und der Sicherheitstechnik immer mehr durch, da sie auf kleinstem Raum über eine lange Zeit und ohne Verwendung einer Spannungsversorgung Daten abspeichern können.

Hierbei gibt es eine Vielzahl von unterschiedlichen Speicherelement-Typen, wobei sich die vorliegende Erfindung insbesondere auf eine sogenannte Split-Gate-Speicherzelle bezieht.

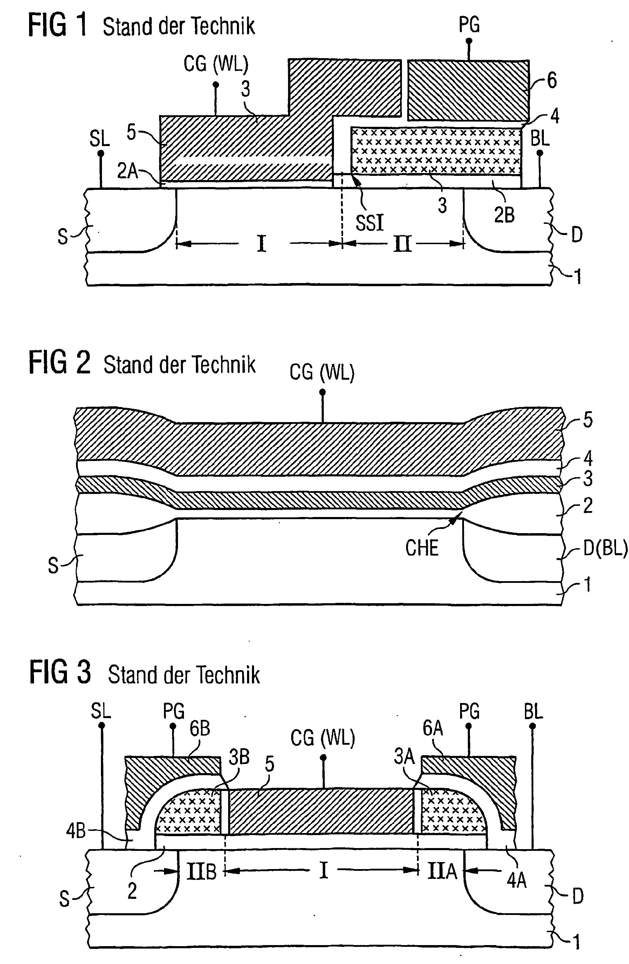

Figur 1 zeigt eine vereinfachte Schnittansicht eines derartigen herkömmlichen Split-Gate-Speicherelements.

Gemäß Figur 1 ist ein in einem Halbleitersubstrat 1 zwischen einem Sourcegebiet S und einem Draingebiet D liegendes Kanalgebiet in einen ersten Teilabschnitt I und einen .zweiten Teilabschnitt II aufgeteilt, wobei im ersten Teilabschnitt eine Steuerschicht 5 unmittelbar über dem Kanalgebiet ausgebildet und von diesem durch eine erste Isolierschicht 2A getrennt ist, während es in einem zweiten Teilabschnitt II nur mittelbar über dem Kanalgebiet bzw. Halbleitersubstrat 1 liegt. Zur Realisierung der erwünschten ladungsspeichernden Eigenschaften ist im zweiten Teilabschnitt II vielmehr eine Ladungsspeicherschicht 3 über dem Kanalgebiet bzw. Halbleitersubstrat 1 ausgebildet und von diesem durch eine zweite Isolierschicht bzw. Tunnelschicht 2B isoliert.

Zur Realisierung einer sogenannten sourceseitigen Ladungsträgerinjektion (SSI, Source Side Injection) besitzt das Split-Gate-Speicherelement gemäß Figur 1 ferner eine Programmierschicht 6, die im Wesentlichen an der Oberfläche der Ladungsspeicherschicht 3 ausgebildet und von dieser durch eine dritte Isolierschicht 4 getrennt bzw. isoliert ist.

Zur Programmierung bzw. zum Einbringen von Ladungsträgern in die Ladungsspeicherschicht 3 wird eine an der Programmierschicht 6 angeschlossene Programmierelektrode PG, eine an der Steuerschicht 5 angeschlossene Steuerelektrode CG, eine an dem Sourcegebiet S angeschlossene Sourceleitung SL und eine an dem Draingebiet D angeschlossene Bitleitung BL derart beschaltet, dass sich am Übergang zwischen dem ersten und zweiten Teilabschnitt I und II ein derart hohes elektrisches Feld im Kanalbereich einstellt, dass vom Sourcegebiet S kommende Elektronen auf Grund des vorliegenden hohen Potentialgefälles derart beschleunigt werden, dass sie in die Ladungsspeicherschicht injiziert werden. Eine derartige Programmierung unter SSI-Bedingungen (Source Side Injection) verlängert eine Lebensdauer von Speicherelementen auf Grund der verringerten Beanspruchung der Isolierschichten im Vergleich zu den exzessiven elektrischen Feldern, die für eine drainseitige Ladungsträgerinjektion erforderlich sind. Darüber hinaus ist eine Programmierung unter SSI-Bedingung wesentlich effizienter als eine drainseitige Ladungsträgerinjektion, wodurch insbesondere die Zeitdauer für eine jeweilige Programmierung verringert werden oder bei gleicher Programmierzeit der Kanalstrom und damit der Leistungsverbrauch reduziert werden kann. Insbesondere können jedoch bei Speicherelementen mit sourceseitiger Ladungsträgerinjektion die Betriebsspannungen wesentlich verringert werden.

Nachteilig bei derartigen Speicherelementen mit sourceseitiger Ladungsträgerinjektion ist jedoch der erheblich höhere Konstruktionsaufwand, der sich insbesondere aus den drei getrennten Steuerschichten - Ladungsspeicherschicht 3, Programmierschicht 6 und Steuerschicht 5 - ergibt. Insbesondere auf Grund der zusätzlichen Programmierschicht 6 und einer fehlenden Selbstjustierung sind hohe Integrationsdichten für derartige Split-Gate-Speicherelemente nur bedingt zu realisieren.

Figur 2 zeigt eine vereinfachte Schnittansicht eines weiteren nichtflüchtigen Speicherelements, wobei im Wesentlichen eine sogenannte CHE-Ladungsträgerinjektion drainseitig mittels heißer Ladungsträger aus dem Kanal (CHE, Channel Hot Electron) erfolgt.

Gemäß Figur 2 besteht ein derartiges nichtflüchtiges Speicherelement aus einem Halbleitersubstrat 1, in dem ein Sourcegebiet S, ein Draingebiet D und ein dazwischen liegendes Kanalgebiet ausgebildet sind, wobei eine Ladungsspeicherschicht 3 durch eine erste Isolierschicht 2 vom Kanalgebiet getrennt auf diesem ausgebildet ist und wiederum zum Speichern von Ladungsträgern geeignet ist. An der Oberfläche der Ladungsspeicherschicht 3 befindet sich wiederum eine Steuerschicht 5, die durch eine weitere Isolierschicht 4 von der Ladungsspeicherschicht 3 getrennt ist.

Im Gegensatz zur vorstehend beschriebenen Split-Gate-Speicherzelle mit sourceseitiger Ladungsträgerinjektion benötigt diese nichtflüchtige Speicherzelle lediglich drei Kontaktanschlüsse nämlich eine Steuerelektrode CG bzw. Wortleitung WL zum Anschließen der Steuerschicht 5 sowie eine Sourceleitung SL zum Anschließen des Sourcegebiets S und eine Bitleitung BL zum Anschließen des Draingebiets. Der Aufbau und somit auch die Herstellung einer derartigen herkömmlichen Speicherzelle ist demzufolge wesentlich vereinfacht, wobei insbesondere auf Grund eines fehlenden Kontaktanschlusses für eine Programmierschicht eine erhöhte Integrationsdichte realisiert werden kann.

Nachteilig bei einer derartigen nichtflüchtigen Speicherzelle ist jedoch der Einsatz von notwendigen und hohen Betriebsspannungen um eine Kanalinjektion mittels heißer Ladungsträger CHE (Channel Hot Electron) zu realisieren. Diese hohen Drain- und Gate-Spannungen resultieren insbesondere aus dem Bestreben die Programmierzeit zu verkürzen, weshalb im Wesentlichen in der Nähe der Durchbruchsspannungen programmiert wird. Derartige Hochspannungen zur Realisierung einer Ladungsträgerinjektion unter CHE-Bedingungen benötigen folglich zusätzliche Spannungsversorgungsschaltungen und eine außerordentlich hohe Beanspruchung der vorliegenden Isolierschichten.

Figur 3 zeigt eine vereinfachte Schnittansicht eines weiteren herkömmlichen nichtflüchtigen Halbleiterspeicherelements zum Abspeichern von zwei Bits, wie sie beispielsweise aus der Druckschrift US 6,366,500 bekannt ist.

Gemäß Figur 3 ist wiederum in einem Halbleitersubstrat 1 ein Sourcegebiet S und ein Draingebiet D mit einem dazwischen liegenden Kanalgebiet ausgebildet, welches einen ersten Teilabschnitt I und zwei zweite Teilabschnitte IIA und IIB sourceseitig und drainseitig aufweist. An der Oberfläche des Halbleitersubstrats 1 bzw. des Kanalgebiets befindet sich wiederum eine erste Isolierschicht als Gatedielektrikum bzw. als Tunneldielektrikum, wobei im ersten Teilabschnitt I an der Oberfläche der ersten Isolierschicht 2 eine Steuerschicht 5 ausgebildet und in den beiden zweiten Teilabschnitten IIA. und IIB des Kanalgebiets jeweils eine drainseitige Ladungsspeicherschicht 3A und eine sourceseitige Ladungsspeicherschicht 3B ausgebildet ist, welche als elektrisch leitende Floating Gates dotiertes Polysilizium aufweisen.

Zur Realisierung der vorstehend genannten sourceseitigen Ladungsträgerinjektion bzw. der SSI-Bedingung (Source Side Injection) befinden sich an den Ladungsspeicherschichten 3A und 3B jeweiligen drainseitige und sourceseitige Programmierschichten 6A und 6B, die durch eine weitere Isolierschicht 4A und 4B von der jeweiligen Ladungsspeicherschicht 3A und 3B getrennt bzw. isoliert sind.

Auf diese Weise erhält man zwar eine sogenannte Dual-Bit-Split-Gate-Speicherzelle mit sourceseitiger Ladungsinjektion, wobei jedoch wiederum auf Grund der verwendeten Programmierschichten 6A und 6B eine erhöhte Komplexität und ein erhöhter Platzbedarf vorliegt.

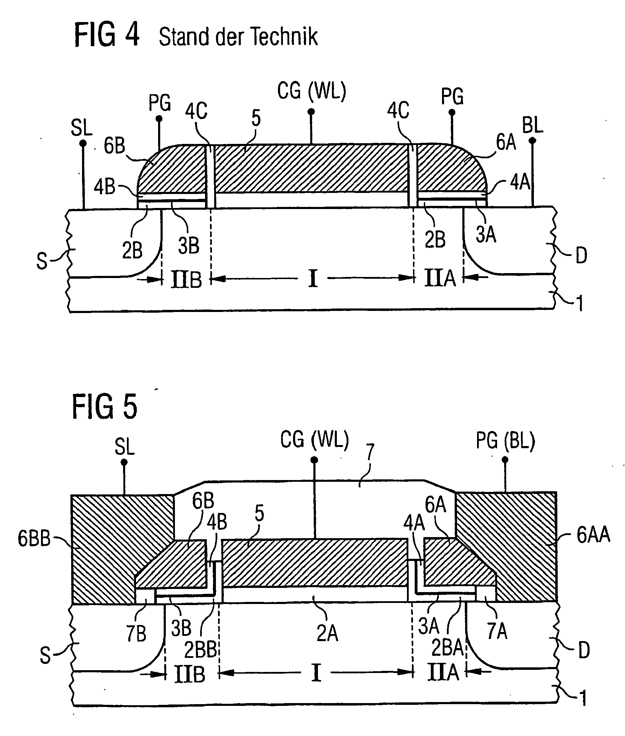

Figur 4 zeigt eine vereinfachte Schnittansicht einer weiteren herkömmlichen Dual-Bit Split-Gate-Speicherzelle wobei gleiche Bezugszeichen wiederum gleiche oder entsprechende Elemente wie in den Figuren 1 bis 3 beschreiben und auf eine wiederholte Beschreibung nachfolgend verzichtet wird.

Gemäß Figur 4 können wiederum zwei Speicherzustände, d.h. zwei Bits, sourceseitig und drainseitig in einer Ladungsspeicherschicht 3A und 3B abgelegt werden, wobei jedoch ein derartiges Speicherelement als Ladungsspeicherschicht eine elektrisch nicht leitende Siliziumnitrid-Schicht verwendet. Wiederum ergeben sich bei einem derartigen Split-Gate-Speicherelement, wie es beispielsweise aus der Druckschrift US 5,408,115 bekannt ist, auf Grund der einstellbaren SSI-Bedingung günstige bzw. niedrige Programmierspannungen, wobei jedoch wiederum eine Komplexität und ein Platzbedarf zur Realisierung eines derartigen Speicherelements sehr hoch sind.

Die Druckschrift US 5 436 479 offenbart ein nichtflüchtiges Halbleiterspeicherelement mit einem Halbleitersubstrat, in dem ein Sourcegebiet, ein Draingebiet und ein dazwischen liegendes Kanalgebiet ausgebildet sind, wobei eine Ladungsspeicherschicht über dem gesamten Kanalgebiet ausgebildet ist und über der Ladungsspeicherschicht in einem sourceseitigen Teilabschnitt eine Steuerschicht und in einem drainseitigen Teilabschnitt eine elektrisch leitende Verbindungsschicht ausgebildet ist. Die Verbindungsschicht ist hierbei mit dem Draingebiet verbunden, wodurch man eine hohe kapazitive Kopplung zwischen Drain und Ladungsspeicherschicht erhält. Dadurch kann eine unerwünschte drainseitige CHE-Ladungsträgerinjektion durch Fowler-Nordheim-Tunneln ersetzt werden.

Aus der weiteren Druckschrift US 5 654 568 ist ein herkömmliches nichtflüchtiges Halbleiterspeicherelement bekannt, wobei wiederum über dem gesamten Kanalgebiet eine Ladungsspeicherschicht ausgebildet ist. Drainseitig ist an ihrer Oberfläche eine Steuerschicht zur Realisierung eines ersten Kanalabschnitts ausgebildet, während sourceseitig eine Isolierschicht zur Realisierung eines zweiten Kanalabschnitts ausgebildet ist. In einem Programmierschritt ist hierbei nur der erste Kanalabschnitt leitend, während in einem Leseschritt auch der zweite Kanalabschnitt leitend werden kann.

Die Druckschrift US 6 249 022, auf der der Oberbegriff des Patentanspruchs 1 basiert, offenbart ein nichtflüchtiges Halbleiterspeicherelement, wobei in einem Halbleitersubstrat ein Sourcegebiet ein Draingebiet und ein dazwischen liegendes Kanalgebiet ausgebildet sind. Eine Steuerschicht ist auf einem ersten Teilabschnitt des Kanalgebiets ausgebildet und von diesem durch eine erste Isolierschicht isoliert. Ferner ist eine source- bzw. drainseitige Ladungsspeicherschicht auf einem zweiten source- bzw. drainseitigen Teilabschnitt des Kanalgebiets ausgebildet und von diesem durch eine zweite source- bzw. drainseitige Isolierschicht isoliert.

Der Erfindung liegt die Aufgabe zu Grunde ein nichtflüchtiges Halbleiterspeicherelement sowie ein zugehöriges Herstellungs- und Ansteuerverfahren zu schaffen, mit dem bei günstigen Programmierbedingungen ein vereinfachter Aufbau zu realisieren ist.

Erfindungsgemäß wird diese Aufgabe hinsichtlich des Halbleiterspeicherelements durch die Merkmale des Patentanspruchs 1, hinsichtlich des Herstellungsverfahrens durch die Maßnahmen des Patentanspruchs 5 und hinsichtlich des Ansteuerverfahrens durch die Maßnahmen der Patentansprüche 13 bis 15 gelöst.

Insbesondere durch die Verwendung von dotiertem Polysilizium für die Steuerschicht, Programmierschicht und Verbindungsschicht kann ein nichtflüchtiges Halbleiterspeicherelement planar, einfach und somit kostengünstig realisiert werden.

Vorzugsweise besteht eine Ladungsspeicherschicht aus einer elektrisch nicht leitenden Isolierschicht wie z.B. einer Si₃N₄- oder ZrO₂-Schicht, wodurch man eine weitergehende Erhöhung der Integrationsdichte erhält.

Hinsichtlich des Verfahrens kann insbesondere durch das Ausbilden einer Schichtenfolge bestehend aus einer zweiten Isolierschicht, einer Ladungsspeicherschicht und einer dritten Isolierschicht an der Oberfläche eines Halbleitersubstrats und einer strukturierten Steuerschicht und einem nachfolgenden Spacer-Verfahren zum Ausbilden und Strukturieren jeweiliger Programmierschichten, wobei die Steuerschicht, Programmierschicht und Verbindungsschicht dotiertes Polysilizium auf weisen, ein Dual-Bit Split-Gate-Speicherelement auf besonders einfache und kostengünstige Art und Weise hergestellt werden.

Hinsichtlich des Ansteuerverfahrens werden zur Realisierung eines Einschreibens von Informationen in die Speicherzelle zum Erzeugen einer SSI-Bedingung (Source Side Injection) entsprechende Schreibspannungen an die sourceseitigen und drainseitigen Verbindungsschichten sowie die Steuerschicht ange legt, weshalb geringe Schreib-Betriebsspannungen realisiert werden können.

Andererseits können zum Löschen von Informationen derartige Löschspannungen an die drainseitige Verbindungsschicht sowie an die Steuerschicht angelegt werden, dass sich eine Lawineneffekt-Bedingung im Kanal ergibt und wiederum relativ geringe Betriebsspannungen notwendig sind.

Zum Auslesen einer Information werden entsprechende Lesespannungen an die sourceseitigen und drainseitigen Verbindungsschichten sowie die Steuerschicht derart angelegt, dass sich vorzugsweise eine sogenannte rückwärts gerichtete Auslesebedingung (reverse read-out) im Speicherelement ergibt.

Auf diese Weise können trotz des Fehlens von separaten Anschlüssen für die jeweiligen Programmierschichten alle notwendigen Ansteuerbedingungen für die erfindungsgemäße Split-Gate-Speicherzelle geschaffen werden.

In den Unteransprüchen sind weitere vorteilhafte Ausgestaltungen der Erfindung gekennzeichnet.

Die Erfindung wird nachfolgend anhand eines Ausführungsbeispiels unter Bezugnahme auf die Zeichnung näher beschrieben.

Es zeigen:
Figur 1 eine vereinfachte Schnittansicht eines Split-Gate-Speicherelements gemäß dem Stand der Technik;
Figur 2 eine vereinfachte Schnittansicht eines nichtflüchtigen Speicherelements gemäß dem Stand der Technik;
Figur 3 eine vereinfachte Schnittansicht eines Dual-Bit Split-Gate-Speicherelements gemäß dem Stand der Technik;
Figur 4 eine vereinfachte Schnittansicht eines weiteren Dual-Bil Split-Gate-Speicherelements gemäß dem Stand der Technik;
Figur 5 eine vereinfachte Schnittansicht eines erfindungsgemäßen Dual-Bit Split-Gate-Speicherelements; und
Figuren 6A bis 6G vereinfachte Schnittansichten zur Veranschaulichung wesentlicher Verfahrensschritte bei der Herstellung des erfindungsgemäßen Dual-Bit Split-Gate-Speicherelements gemäß Figur 5.

Die Erfindung wird nachstehend anhand eines Dual-Bit Split-Gate-Speicherelements zum Ablegen von zwei Speicherzuständen in einem sourceseitigen und drainseitigen Bereich beschrieben, wobei jedoch grundsätzlich auch entsprechende nichtflüchtige Halbleiterspeicherelemente zum Abspeichern von lediglich einem einzelnen Zustand denkbar sind. Insbesondere sei darauf hingewiesen, dass auf Grund der in den Figuren dargestellten Symmetrie des Speicherelements das Sourcegebiet und das Draingebiet äquivalent zu betrachten sind und folglich auch entsprechend vertauscht werden können. Dies gilt in gleicher Weise insbesondere für die sourceseitigen sowie drainseitigen Schichten, wobei lediglich ein Vertauschen von jeweiligen Anschlusspotentialen notwendig ist.

Figur 5 zeigt eine vereinfachte Schnittansicht eines erfindungsgemäßen Dual-Bit Split-Gate-Speicherelements, wobei gleiche Bezugszeichen gleiche oder entsprechende Schichten und Elemente wie in den Figuren 1 bis 4 darstellen und auf eine wiederholte Beschreibung nachfolgend verzichtet wird.

Gemäß Figur 5 ist in einem Halbleitersubstrat 1, welches vorzugsweise ein Silizium-Halbleitersubstrat aufweist, ein Sourcegebiet S, ein Draingebiet D und ein dazwischen liegendes Kanalgebiet ausgebildet, wobei diese Struktur beispielsweise einer PMOS- oder NMOS-Transistorstruktur entspricht und entsprechende p- und n-Dotierungen aufweist. Zur Realisierung eines sogenannten geteilten Gate-Bereichs bzw. Split-Gates besitzt das Kanalgebiet einen ersten Teilabschnitt I, der im Wesentlichen in einem mittleren Bereich des Kanalgebiets liegt und zwei zweite Teilabschnitte IIA und IIB, die in drainseitigen und sourceseitigen Bereichen des Kanalgebiets an den ersten Teilabschnitt I angrenzen und sich bis zum Sourcegebiet S und Draingebiet D erstrecken.

Gemäß Figur 5 ist auf dem ersten Teilabschnitt I des Kanalgebiets eine elektrisch leitende Steuerschicht 5 ausgebildet, die vom Kanalgebiet durch eine erste Isolierschicht 2A isoliert ist. Die Steuerschicht 5 besteht beispielsweise aus einer hochdotierten Polysiliziumschicht, wobei die erste Isolierschicht 2A ein Gatedielektrikum darstellt und vorzugsweise SiO₂ aufweist. Andererseits befindet sich auf den beiden zweiten Teilabschnitten IIA und IIB des Kanalgebiets jeweils eine drainseitige und sourceseitige Ladungsspeicherschicht 3A und 3B, die vom Kanalgebiet durch eine zweite Isolierschicht 2BA und 2BB getrennt bzw. isoliert ist, wobei die zweite Isolierschicht 2BA und 2BB auch identisch mit der ersten Isolierschicht 2 sein kann.

Die Ladungsspeicherschichten bestehen vorzugsweise aus einer elektrisch nicht leitenden Isolierschicht wie z.B. einer Siliziumnitridschicht, wodurch sich geringe Schichtdicken bei günstigen Ladungshalteeigenschaften bzw. Isolationseigenschaften ergeben. Grundsätzlich können jedoch auch andere Isolierschichten wie beispielsweise ZrO₂, HFO₂ oder auch herkömmliche elektrisch leitende Floatinggate-Schichten als Ladungsspeicherschichten 3A und 3B verwendet werden. Im Bereich der drainseitigen und sourceseitigen Ladungsspeicherschichten 3A und 3B sind ferner elektrisch leitende Programmierschichten 6A und 6B drainseitig und sourceseitig ausgebildet, die durch eine dritte Isolierschicht 4A und 4B (z.B. SiO₂) jeweils von der Ladungsspeicherschicht 3A und 3B getrennt bzw. isoliert sind.

Im Unterschied zum Stand der Technik sind diese drainseitigen und sourceseitigen Programmierschichten 6A und 6B nunmehr jedoch nicht getrennt von dem Sourcegebiet S und dem Draingebiet D ansteuerbar, sondern drainseitig und sourceseitig über eine jeweilige Verbindungsschicht 6AA und 6BB elektrisch direkt miteinander verbunden. Auf diese Weise erhält man ein Split-Gate-Speicherelement mit verringerter Anzahl von Anschlusskontakten insbesondere für die herkömmlicherweise verwendeten Programmierelektroden PG, wobei nunmehr lediglich eine Sourceleitung SL zum Anschließen des Sourcegebiets S und der sourceseitigen Programmierschicht 6B an eine Programmierelektrode PG und eine Bitleitung BL zum gleichzeitigen Anschließen des Draingebiets D und der drainseitigen Programmierschicht 6A über die drainseitige Verbindungsschicht 6AA ausgebildet ist. Eine Steuerelektrode CG bzw. Wortleitung WL dient wiederum zum Anschließen der Steuerschicht 5.

Demzufolge kann bei wesentlich verringertem Platzbedarf für das integrierte Speicherelement weiterhin eine sourceseitige Ladungsträgerinjektion realisiert werden, weshalb sich günstige bzw. geringe Betriebsspannungen ergeben.

Als Materialien für die dritte Isolierschichten 4A und 4B werden vorzugsweise Oxidschichten wie z.B. SiO₂ verwendet, wodurch sich für die Schichtenfolge in den beiden zweiten Teilabschnitten IIA und IIB eine sogenannte ONO-Schichtenfolge (Oxid/Nitrid/Oxid) ergibt, die auf Grund ihrer Bandstruktur hervorragende Isoliereigenschaften aufweist.

In gleicher Weise wie die Steuerschicht 5 kann auch die Programmierschicht 6A und 6B sowie die zugehörige Verbindungsschicht 6AA und 6BB hochdotiertes Polysilizium aufweisen, wodurch man unter Verwendung von Standardmaterialien eine besonders einfache Prozessierung und damit ein kostengünstiges Speicherelement erhält.

Zur Isolierung der Steuerschicht 5 sowie der Programmierschichten und Verbindungsschichten wird vorzugsweise eine vierte Isolierschicht 7, die wiederum aus Siliziumdioxid besteht, verwendet, wobei sich diese vierte Isolierschicht als drainseitige und sourceseitige vierte Teil-Isolierschicht 7A und 7B auch in einer oberflächennahen Aussparung von zumindest der Ladungsspeicherschichten 3A und 3B befinden kann, wodurch man eine verbesserte Isolierung dieser Ladungsspeicherschicht insbesondere zu den Verbindungsschichten 6AA und 6BB erhält. Diese oberflächennahe Aussparung wurde vor der Abscheidung der Isolierschicht 7 mittels einer isotropen Ätzung erreicht.

Insbesondere bei Verwendung von elektrisch isolierenden Ladungsspeicherschichten 3A und 3B können diese Teil-Isolierschichten 7A und 7B jedoch auch entfallen, da die eingebrachten Ladungsträger im Wesentlichen am Übergang der Teilabschnitte I zu IIA oder IIB in der Ladungsspeicherschicht 3A und 3B eingelagert werden und ein Wandern dieser Ladungsträger innerhalb der Ladungsspeicherschicht im Wesentlichen nicht stattfindet.

Demzufolge erhält man SSI-Split-Gate-Speicherelemente die bei vereinfachtem Aufbau und verringertem Platzbedarf günstige Betriebsspannungen aufweisen.

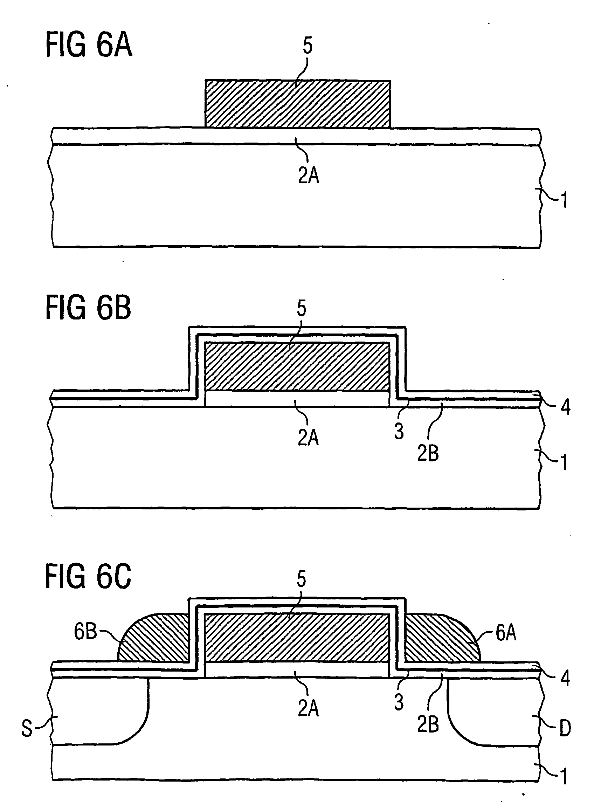

Figuren 6A bis 6G zeigen vereinfachte Schnittansichten zur Veranschaulichung wesentlicher Verfahrensschritte bei der Herstellung des erfindungsgemäßen SSI-Split-Gate-Speicherelements, wobei gleiche Bezugszeichen wiederum gleiche oder entsprechende Schichten bzw. Elemente wie in Figur 5 bezeichnen und auf eine wiederholte Beschreibung nachfolgend verzichtet wird.

Gemäß Figur 6A wird zunächst ein Halbleitersubstrat 1 vorbereitet, wobei beispielsweise aktive Gebiete mittels Grabenisolierungen definiert werden oder entsprechende Wannendotierungen vorgenommen werden. An der Oberfläche des Halbleitersubstrats 1 wird anschließend eine erste Isolierschicht 2A als Gatedielektrikum für das Speicherelement ausgebildet, wobei im Falle eines Silizium-Halbleitersubstrats vorzugsweise eine Siliziumdioxidschicht als Gateoxidschicht verwendet wird. Selbstverständlich können auch andere Halbleitermaterialien und andere Gatedielektrika für das Halbleitersubstrat 1 und die erste Isolierschicht 2A verwendet werden.

Anschließend wird beispielsweise mittels eines Abscheideverfahrens eine elektrisch leitende Steuerschicht 5 an der Oberfläche der ersten Isolierschicht 2A ausgebildet und derart strukturiert, dass sich die in Figur 6A dargestellte Schnittansicht ergibt. Vorzugsweise wird als Steuerschicht 5 eine hochdotierte Polysiliziumschicht abgeschieden und mittels eines fotolithographischen Verfahrens zum Ausbilden eines sogenannten Gates strukturiert.

Gemäß Figur 6B kann in einem nachfolgenden Schritt oder gleichzeitig mit der Strukturierung der Steuerschicht 5 auch die erste Isolierschicht 2A strukturiert werden, wodurch lediglich unterhalb der Steuerschicht 5 die erste Isolierschicht 2A als Gatedielektrikum verbleibt. Diese Strukturierung kann jedoch auch entfallen.

Anschließend wird eine Schichtenfolge bestehend aus einer zweiten Isolierschicht 2B, einer Ladungsspeicherschicht 3 und einer dritten Isolierschicht 4 an der Oberfläche des Halbleitersubstrats 1 bzw. an der Oberfläche der ersten Isolierschicht 2A und der strukturierten Steuerschicht 5 ausgebildet, wobei vorzugsweise eine ONO-Schichtenfolgen (Oxid/Nitrid/Oxid) ganzflächig abgeschieden wird und die Siliziumnitridschicht als Ladungsspeicherschicht 3 verwendet wird. Alternativ kann als Ladungsspeicherschicht 3 auch eine andere elektrisch isolierende Ladungsspeicherschicht wie z.B. ZrO₂ oder auch eine elektrisch leitende Ladungsspeicherschicht abgeschieden werden. Insbesondere bei Rückätzung der ersten Isolierschicht 2A und Ausbilden der dargestellten ONO-Schichtenfolge erhält man jedoch eine besonders günstige Schichtenfolge, die eine hohe Integrationsdichte bei einfachem Verfahrensablauf ermöglicht.

Gemäß Figur 6C wird in einem nachfolgenden Verfahrensschritt eine Programmierschicht zunächst ganzflächig abgeschieden und derart strukturiert, dass sich an den Seitenwänden der strukturierten Steuerschicht 5 bzw. der entsprechenden ONO-Schichtenfolge drainseitig und sourceseitig Programmierschichten 6A und 6B ergeben. Vorzugsweise wird hierbei ein sogenanntes Spacer-Verfahren zum Ausbilden der Programmierschichten 6A und 6B verwendet, wobei zunächst beispielsweise eine zweite Polysiliziumschicht als Programmierschicht konformal, d.h. gleich dick, abgeschieden wird und anschließend ein anisotropes Rückätzen erfolgt, wodurch die Programmierschichten 6A und 6B in Form von Spacern an den Seitenwänden der Steuerschicht 5 ausgebildet werden.

Unter Verwendung dieser strukturierten Programmierschichten bzw. Spacer 6A und 6B sowie der strukturierten Steuerschicht 5 mit darüber liegender Schichtenfolge aus zweiter Isolierschicht 2B, Ladungsspeicherschicht 3 und dritter Isolierschicht 4 werden anschließend Sourcegebiete S und Draingebiete D selbstjustierend im Halbleitersubstrat 1 ausgebildet.

Beispielsweise wird hierbei eine Ionenimplantation durchgeführt, wobei zum Ausdiffundieren und Aktivieren der jeweiligen Source- und Draingebiete eine thermische Nachbehandlung durchgeführt werden kann. Zum Rekonstruieren eines eventuell gestörten Kristallgitters kann hierbei auch ein Ausheilverfahren durchgeführt werden.

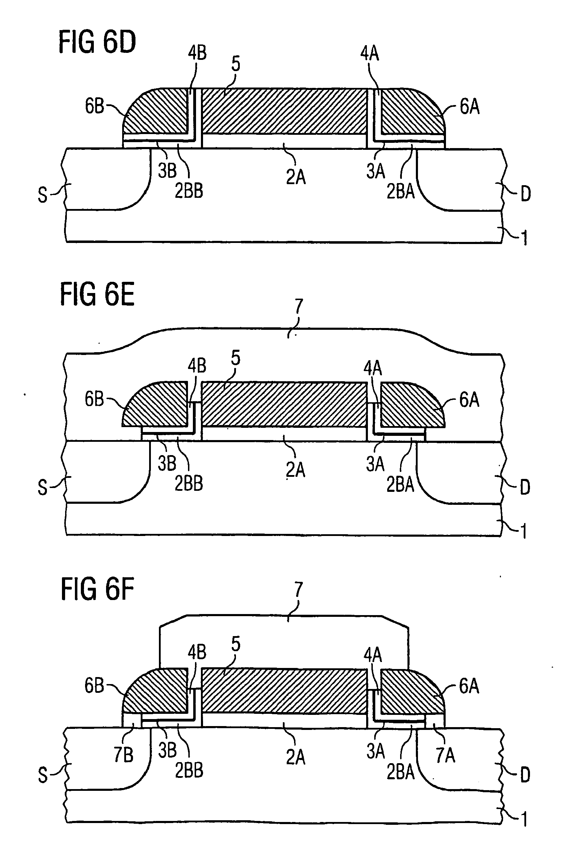

Gemäß Figur 6D wird in einem nachfolgenden Verfahrensschritt die Schichtenfolge bestehend aus der dritten Isolierschicht 4, der Ladungsspeicherschicht 3 und der zweiten Isolierschicht 2B unter Verwendung der Spacer bzw. strukturierten Programmierschichten 6A und 6B derart strukturiert, dass sowohl die Steuerschicht 5 als auch das Halbleitersubstrat 1 bzw. die Source- und Draingebiete S und D freigelegt werden. Vorzugsweise wird für dieses Freilegen der Source- und Draingebiete ein sogenanntes ONO-Trockenätzverfahren durchgeführt.

Auf diese Weise erhält man eine drainseitige und sourceseitige Schichtenfolge bestehend aus einer drainseitigen und sourceseitigen zweiten Isolierschicht 2BA und 2BB, einer drainseitigen und sourceseitigen Ladungsspeicherschicht 3A und 3B sowie einer drainseitigen und sourceseitigen dritten Isolierschicht 4A und 4B.

Optional kann zu diesem Zeitpunkt ein weiteres Rückätzen von zumindest der drainseitigen und sourceseitigen Ladungsspeicherschicht 3A und 3B zum Ausbilden von zumindest oberflächennahen Aussparungen unterhalb der strukturierten Programmierschichten 6A und 6B erfolgen, wodurch sich insbesondere die Isolationseigenschaften bzw. Leckstromeigenschaften wesentlich verbessern lassen. Vorzugsweise wird hierbei ein Nitrid-Ätzverfahren verwendet.

Gemäß Figur 6E wird in einem nachfolgenden Verfahrensschritt eine vierte Isolierschicht 7 an der Oberfläche des Halbleitersubstrats 1 sowie der strukturierten Programmierschichten 6A und 6B und der strukturierten Steuerschicht 5 ausgebildet, wobei auch die in dem optional durchgeführten Rückätzschritt erzeugten Rückätzungen bzw. Aussparungen in zumindest der Ladungsspeicherschicht aufgefüllt werden. Zum Auffüllen der durch beispielsweise ein isotropes Rückätzverfahren optional ausgebildeten Ladungsspeicherschicht-Aussparungen wird beispielsweise eine CVD-Oxid-Abscheidung durchgeführt.

Gemäß Figur 6F erfolgt in einem nachfolgenden Verfahrensschritt ein Freilegen des Sourcegebiets S und des Draingebiets D, wobei zumindest auch Teile der strukturierten drainseitigen und sourceseitigen Programmierschicht 6A und 6B zum Ausbilden von Verbindungsbereichen freigelegt werden. Vorzugsweise wird hierbei ein fotolithographisches Verfahren zum Ausbilden von Kontaktöffnungen bzw. -löchern mit anschließendem anisotropen Trockenätzen durchgeführt.

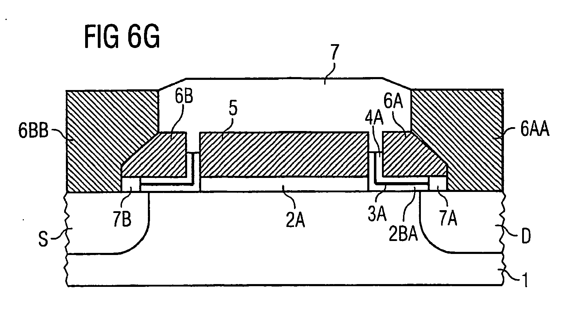

Gemäß Figur 6G wird anschließend eine elektrisch leitende Verbindungsschicht in den freigelegten Verbindungsbereichen, wie z.B. Kontaktöffnungen, zum Kontaktieren der drainseitigen Programmierschicht 6A und des Draingebiets D sowie der sourceseitigen Programmierschicht 6B und des Sourcegebiets S ausgebildet. Vorzugsweise wird hierbei eine dritte Polysiliziumschicht als elektrisch leitende Verbindungsschicht abgeschieden und bis zur vierten Isolierschicht 7 planarisiert, wodurch sich eine drainseitige Verbindungsschicht 6AA und eine sourceseitige Verbindungsschicht 6BB ergibt. Als Planarisier-Verfahren wird beispielsweise ein CMP-Verfahren (Chemical Mechanical Polishing) durchgeführt, welches auf der vierten Isolierschicht 7 stoppt.

Auf diese Weise kann unter Verwendung von Standardverfahren eine SSI-Split-Gate-Speicherzelle mit geringem Flächenbedarf und einfachem Aufbau ausgebildet werden.

Nachfolgend wird wiederum unter Bezugnahme auf die Figur 5 ein Ansteuerverfahren bzw. eine Betriebsweise des erfindungsgemäßen Split-Gate-Speicherelements beschrieben, wobei lediglich die Bedingungen zum Einschreiben, Löschen oder Lesen einer Information bzw. eines Zustands in der rechten Halbseite definiert sind und bei Anlegen entsprechender Spannungen auch ein Schreiben, Löschen oder Lesen eines Zustands in der linken Seite des Speicherelements entsprechend durchgeführt werden kann. Auf Grund der Symmetrie des Speicherelements sind hierbei das Sourcegebiet und das Draingebiet äquivalent und entsprechend austauschbar.

Zum Schreiben einer Information in ein Split-Gate-Speicherelement bzw. zum Programmieren des Speicherelements mittels sourceseitiger Ladungsträgerinjektion (SSI, Source Side Injection) muss das Potential an der Sourceleitung SL bzw. dem Sourcegebiet S und der sourceseitigen Programmierschicht 6B positiv sein, um den Zustand auf der rechten Seite des Speicherelements programmieren zu können. Genauer gesagt wird demzufolge eine erste positive Schreibspannung an die sourceseitige Verbindungsschicht 6BB angelegt, wobei beispielsweise eine erste Schreibspannung von V_{SL} = 2 V angelegt wird. Die drainseitige Spannung bzw. die Spannung an der drainseitigen Programmierschicht 6A und dem Draingebiet D muss gegenüber der ersten positiven Schreibspannung bzw. der Spannung am Sourcegebiet S und sourceseitigen Programmierschicht 6B wesentlich höher sein und beispielsweise eine Spannung von V_{PG} = 6 V als zweite Schreibspannung aufweisen. An die Steuerschicht 5 muss nunmehr zum Erzeugen der vorstehend beschriebenen SSI-Bedingung (Source Side Injection) eine gegenüber der effektiven Schwellwertspannung eines jeweiligen inneren Transistors leicht höhere dritte positive Schreibspannung angelegt werden, wobei beispielsweise eine Spannung von V_{CG} = 1,5 V ausreicht, wenn die Schwellwertspannung V_{T} eines "inneren" Transistors des Speicherelements gleich 1 V aufweist.

Auf diese Weise kann trotz unmittelbarer Kontaktierung der Programmierschichten mit den jeweiligen Source- und Draingebieten eine sourceseitige Ladungsträgerinjektion in der drainseitigen Ladungsspeicherschicht 3A durchgeführt werden, wobei die Betriebsspannungen entsprechend gering sind.

Zum Löschen einer Information - wiederum in der rechten Halbseite des erfindungsgemäßen Split-Gate-Speicherelements - wird demgegenüber an die sourceseitige Verbindungsschicht 6BB ein schwebendes Potential (floating potential) angelegt, während an die drainseitige Verbindungsschicht 6AA eine hohe erste Löschspannung von beispielsweise V_{PG} = 8 V angelegt wird, wodurch mittels eines Lawineneffekts drainseitig heiße Löcher in der Raumladungszone des Draingebiets erzeugt und in die drainseitige Ladungsspeicherschicht 3A eingebracht werden. Zur Verbesserung eines Löschvorgangs kann an die Steuerschicht 5 eine gegenüber der Schwellwertspannung eines jeweiligen "inneren" Transistors niedrigere zweite Löschspannung angelegt werden, wobei vorzugsweise eine negative Spannung verwendet wird.

Zum Lesen einer Information in einer rechten Halbseite des Split-Gate-Speicherelements wird an die sourceseitige Verbindungsschicht 6BB eine erste positive Lesespannung von beispielsweise V_{SL} = 3 V angelegt, während an die drainseitige Verbindungsschicht 6AA eine gegenüber der ersten Lesespannung ausreichend kleinere zweite Lesespannung angelegt wird, die z.B. V_{PG} = 0 V beträgt. Zum Erzeugen einer vorzugsweise rückwärts gerichteten Auslese-Bedingung wird an die Steuerschicht 5 eine im Bereich der ersten Lesenspannung dritte Lesespannung von beispielsweise V_{CG} = 2 bis 5 V angelegt. Hinsichtlich der rückwärts gerichteten Auslesebedingung sei darauf hingewiesen, dass Source und Drain vertauscht sind, wobei die nunmehr sourceseitig, d.h. in Figur 5 drainseitig, eingefangene Ladung einen größeren Einfluss auf den Lesestrom aufweist als die drainseitig, d.h. in Figur 5 sourceseitig, eingefangene Ladung. Diese Ladung wird zwar durch die positive Drainspannung erfasst, hat jedoch einen unwesentlichen Einfluss auf den resultierenden Lesestrom, weshalb auch bei der kurzgeschlossenen Verbindungsschicht mit den Sourcegebieten und Draingebieten ein ausreichend genaues Auslesen von Zuständen in dem erfindungsgemäßen Speicherelement möglich ist. Genauer gesagt wird einerseits bei negativ geladener Ladungsspeicherschicht 3A bzw. 3B ein zugehöriger Kanalabschnitt verarmt (depleted) und somit hochohmig, wodurch sich ein verringerter Lesestrom ergibt. Andererseits wird bei positiv geladener Ladungsspeicherschicht (Löcher) ein zugehöriger Kanalabschnitt niederohmig, wodurch sich ein erhöhter Lesestrom ergibt.

Die Erfindung wurde vorstehend anhand eines Dual-Bit Split-Gate-Speicherelements zum Abspeichern von zwei Zuständen beschrieben. Sie ist jedoch nicht darauf beschränkt und kann in gleicher Weise auch nichtflüchtige Halbleiterspeicherelemente mit lediglich einem Speicherzustand aufweisen. Ferner wurden als Materialien für die elektrisch leitenden Schichten dotierte Polysiliziumschichten beschrieben. Es können auch alternative Materialien für die Isolierschichten sowie für das Halbleitersubstrat verwendet werden.

## Patentansprüche

1. Nichtflüchtiges Halbleiterspeicherelement mit
einem Halbleitersubstrat (1), in dem ein Sourcegebiet (S), ein Draingebiet (D) und ein dazwischen liegendes Kanalgebiet ausgebildet sind;
einer Steuerschicht (5), die auf einem ersten Teilabschnitt (I) des Kanalgebiets ausgebildet und von diesem durch eine erste Isolierschicht (2A) isoliert ist;
einer sourceseitigen Ladungsspeicherschicht (3B), die auf einem zweiten sourceseitigen Teilabschnitt (IIB) des Kanalgebiets ausgebildet und von diesem durch eine zweite sourceseitige Isolierschicht (2BB) isoliert ist;
einer drainseitigen Ladungsspeicherschicht (3A), die auf einem zweiten drainseitigen Teilabschnitt (IIA) des Kanalgebiets ausgebildet und von diesem durch eine zweite drainseitige Isolierschicht (2BA) isoliert ist;
einer sourceseitigen Programmierschicht (6B), die an der sourceseitigen Ladungsspeicherschicht (3B) ausgebildet und von dieser durch eine dritte sourceseitige Isolierschicht (4B) isoliert ist;
einer drainseitigen Programmierschicht (6A), die an der drainseitigen Ladungsspeicherschicht (3A) ausgebildet und von dieser durch eine dritte drainseitige Isolierschicht (4A) isoliert ist;
einer sourceseitigen Verbindungsschicht (6BB), die die sourceseitige Programmierschicht (6B) mit dem Sourcegebiet (S) elektrisch verbindet; und
einer drainseitigen Verbindungsschicht (6AA), die die drainseitige Programmierschicht (6A) mit dem Draingebiet (D) elektrisch verbindet,
**dadurch gekennzeichnet, dass** die Steuerschicht (5), die Programmierschicht (6A, 68) und die Verbindungsschicht (6AA, 6BB) dotiertes Polysilizium aufweist.

2. Nichtflüchtiges Halbleiterspeicherelement nach Patentanspruch 1,
**dadurch gekennzeichnet, dass** die Ladungsspeicherschicht (3A, 3B) eine elektrisch nicht leitende Schicht darstellt.

3. Nichtflüchtiges Halbleiterspeicherelement nach einem der Patentansprüche 1 oder 2,
**dadurch gekennzeichnet, dass** die erste und zweite Isolierschicht (2A, 2BA, 2BB) SiO₂ aufweist.

4. Nichtflüchtiges Halbleiterspeicherelement nach einem der Patentansprüche 1 bis 3,
**dadurch gekennzeichnet, dass** die Ladungsspeicherschicht (3A, 3B) eine Si₃N₄-, HFO₂ oder ZrO₂-Schicht aufweist.

5. Verfahren zur Herstellung eines nichtflüchtigen Halbleiterspeicherelements mit den Schritten:
a) Vorbereiten eines Halbleitersubstrats (1);
b) Ausbilden einer ersten Isolierschicht (2A) an der Oberfläche des Halbleitersubstrats (1);
c) Ausbilden und Strukturieren einer Steuerschicht (5) an der Oberfläche der ersten Isolierschicht (2A), wobei die Steuerschicht dotiertes Polysilizium aufweist;
d) Ausbilden einer Schichtenfolge bestehend aus einer zweiten Isolierschicht (2B), einer Ladungsspeicherschicht (3) und einer dritten Isolierschicht (4) an der Oberfläche des Halbleitersubstrats (1) und der strukturierten Steuerschicht (5);
e) Ausbilden und Strukturieren einer Programmierschicht (6A, 6B) auf der dritten Isolierschicht (4) an den Seitenwänden der strukturierten Steuerschicht (5), wobei die Programmierschicht dotiertes Polysilizium aufweist;
f) Ausbilden von Sourcegebieten (S) und Draingebieten (D) im Halbleitersubstrat (1) unter Verwendung der strukturierten Programmierschicht (6A, 6B) und der strukturierten Steuerschicht (5) als Maske;
g) Strukturieren der dritten Isolierschicht (4), der Ladungsspeicherschicht (3) und der zweiten Isolierschicht (28) unter Verwendung der strukturierten Programmierschicht (6A, 6B) als Maske;
h) Ausbilden einer vierten Isolierschicht (7) an der Oberfläche des Halbleitersubstrats (1), der strukturierten Programmierschicht (6A, 6B) und der strukturierten Steuerschicht (5);
i) Freilegen von Verbindungsbereichen zumindest an Teilen der strukturierten Programmierschicht (6A, 6B), des Sourcegebiets (S) und des Draingebiets (D); und
j) Ausbilden einer elektrisch leitenden Verbindungsschicht (6AA, 6BB) in den freigelegten Verbindungsbereichen zum Kontaktieren der Programmierschicht (6A, 6B) des Sourcegebiets (S) und des Draingebiets (D), wobei die Verbindungsschicht dotiertes Polysilizium aufweist.

6. Verfahren nach Patentanspruch 5,
**dadurch gekennzeichnet, dass** in Schritt b) ein Gatedielektrikum als erste Isolierschicht (2A) ausgebildet wird.

7. Verfahren nach einem der Patentansprüche 5 oder 6,
**dadurch gekennzeichnet, dass** in Schritt d) eine ONO-Schichtenfolge abgeschieden wird.

8. Verfahren nach einem der Patentansprüche 5 bis 7,
**dadurch gekennzeichnet, dass** in Schritt e) ein Spacer-Verfahren zum Abscheiden und Strukturieren der Programmierschicht (6A, 6B) durchgeführt wird.

9. Verfahren nach einem der Patentansprüche 5 bis 8,
**dadurch gekennzeichnet, dass** in Schritt f) eine Ionenimplantation und eine thermische Nachbehandlung zum Ausdiffundieren und Aktivieren der Source- und Draingebiete (S, D) durchgeführt wird.

10. Verfahren nach einem der Patentansprüche 5 bis 9,
**dadurch gekennzeichnet, dass** in Schritt g) ein anisotropes Trockenätzen der Schichtenfolge und ein isotropes Rückätzen von zumindest der Ladungsspeicherschicht (3) zum Ausbilden von Ladungsspeicherschicht-Aussparungen durchgeführt wird.

11. Verfahren nach Patentanspruch 10,
**dadurch gekennzeichnet, dass** in Schritt h) eine Oxid-Abscheidung zum Auffüllen der Ladungsspeicherschicht-Aussparungen durchgeführt wird.

12. Verfahren nach einem der Patentansprüche 5 bis 11,
**dadurch gekennzeichnet, dass** in Schritt j) die Verbindungsschicht (6AA, 6BB) abgeschieden und planarisiert wird.

13. Verfahren zum Schreiben einer Information in ein nichtflüchtiges Halbleiterspeicherelement nach einem der Patentansprüche 1 bis 4 mit den Schritten:
a) Anlegen einer ersten positiven Schreibspannung an die sourceseitige Verbindungsschicht (6BB);
b) Anlegen einer gegenüber der ersten positiven Schreibspannung wesentlich höheren zweiten positiven Schreibspannung an die drainseitige Verbindungsschicht (6AA); und
c) Anlegen einer gegenüber der effektiven Schwellwertspannung eines jeweiligen inneren Transistors leicht höheren dritten positiven Schreibspannung an die Steuerschicht (5), zum Erzeugen einer Source Side Injection-Bedingung.

14. Verfahren zum Löschen einer Information in einem nichtflüchtigen Halbleiterspeicherelement nach einem der Patentansprüche 1 bis 4 mit den Schritten:
a) Anlegen eines schwebenden Potentials an die sourceseitige Verbindungsschicht (6BB);
b) Anlegen einer hohen ersten Löschspannung an die drainseitige Verbindungsschicht (6AA); und
c) Anlegen einer gegenüber der effektiven Schwellwertspannung eines jeweiligen inneren Transistors niedrigeren zweiten Löschspannung an die Steuerschicht (5), zum Erzeugen einer Lawineneffekt-Bedingung.

15. Verfahren zum Lesen einer Information in einem nichtflüchtigen Halbleiterspeicherelement nach einem der Patentansprüche 1 bis 4 mit den Schritten:
a) Anlegen einer ersten positiven Lesespannung an die sourceseitige Verbindungsschicht (6BB);
b) Anlegen einer gegenüber der ersten Lesespannung ausreichend kleineren zweiten Lesespannung an die drainseitige Verbindungsschicht (6AA); und
c) Anlegen einer im Bereich der ersten Lesespannung liegenden dritten Lesespannung an die Steuerschicht (5) zum Erzeugen einer rückwärtsgerichteten Auslese-Bedingung.

## Claims

1. Nonvolatile semiconductor storage element with a semiconductor substrate (1) in which a source region (S), a drain region (D) and an intermediate channel region are formed;
a control layer (5) which is formed on a first part section (I) of the channel region and is insulated from this by a first insulating layer (2A);
a source side charge storage layer (3B) which is formed on a second source side part section (IIB) of the channel region and is insulated from that by a second source side insulating layer (2BB);
a drain side charge storage layer (3A) which is formed on a second drain side part section (IIA) of the channel region and is insulated from that by a second drain side insulating layer (2BA);
a source side programming layer (6B) which is formed on the source side charge storage layer (3B) and is insulated from that by a third source side insulating layer (4B);
a drain side programming layer (6A) which is formed on the drain side charge storage layer (3A) and is insulated from that by a third drain side insulating layer (4A);
a source side interconnect layer (6BB) which electrically connects the source side programming layer (6B) to the source region (S); and
a drain side interconnect layer (6AA) which electrically connects the drain side programming layer (6A) to the drain region (D);
**characterized in that** the control layer (5), the programming layer (6A, 6B) and the interconnect layer (6AA, 6BB) have doped polysilicon.

2. Nonvolatile semiconductor storage element according to Claim 1, **characterized in that** the charge storage layer (3A, 3B) represents an electrically nonconductive layer.

3. Nonvolatile semiconductor storage element according to one of Claims 1 or 2, **characterized in that** the first and second insulating layer (2A, 2BA, 2BB) exhibits SiO₂.

4. Nonvolatile semiconductor storage element according to one of Claims 1 to 3, **characterized in that** the charge storage layer (3A, 3B) exhibits an Si₃N₄, HFO₂ or ZrO₂ layer.

5. Method for producing a nonvolatile semiconductor storage element with the following steps:
a) preparing a semiconductor substrate (1);
b) forming a first insulating layer (2A) on the surface of the semiconductor substrate (1);
c) forming and patterning a control layer (5) on the surface of the first insulating layer (2A), the control layer having doped polysilicon;
d) forming a sequence of layers consisting of a second insulating layer (2B), a charge storage layer (3) and a third insulating layer (4) on the surface of the semiconductor substrate (1) and of the patterned control layer (5);
e) forming and patterning a programming layer (6A, 6B) on the third insulating layer (4) on the side walls of the patterned control layer (5), the programming layer having doped polysilicon;
f) forming source regions (S) and drain regions (D) in the semiconductor substrate (1) by using the patterned programming layer (6A, 6B) and the patterned control layer (5) as a mask;
g) patterning the third insulating layer (4), the charge storage layer (3) and the second insulating layer (2B) by using the patterned programming layer (6A, 6B) as a mask;
h) forming a fourth insulating layer (7) on the surface of the semiconductor substrate (1), of the patterned programming layer (6A, 6B) and of the patterned control layer (5);
i) exposing interconnect areas at least of parts of the patterned programming layer (6A, 6B), of the source region (S) and of the drain region (D); and
j) forming an electrically conductive interconnect layer (6AA, 6BB) in the exposed interconnect areas for contacting the programming layer (6A, 6B) of the source region (S) and of the drain region (D), the interconnect layer having doped polysilicon.

6. Method according to Claim 5, **characterized in that** a gate dielectric is formed as the first insulating layer (2A) in step b).

7. Method according to one of Claims 5 or 6, **characterized in that** an ONO sequence of layers is deposited in step d).

8. Method according to one of Claims 5 to 7, **characterized in that** a spacer method is performed for depositing and patterning the programming layer (6A, 6B) in step e).

9. Method according to one of Claims 5 to 8, **characterized in that** an ion implantation and a thermal post-treatment is performed for diffusing-out and activating the source and drain regions (S, D) in step f).

10. Method according to one of Claims 5 to 9, **characterized in that** an anisotropic dry etching of the sequence of layers and an isotropic etching-back of at least the charge storage layer (3) is performed for forming charge storage layer recesses in step g).

11. Method according to Claim 10, **characterized in that** an oxide deposition is performed for filling up the charge storage layer recesses in step h).

12. Method according to one of Claims 5 to 11, **characterized in that** the interconnect layer (6AA, 6BB) is deposited and planarized in step j).

13. Method for writing an information item into a nonvolatile semiconductor storage element according to one of Claims 1 to 4, with the following steps:
a) applying a first positive write voltage to the source side interconnect layer (6BB);
b) applying a second positive write voltage, which is much higher than the first positive write voltage, to the drain side interconnect layer (6AA); and
c) applying a third positive write voltage, which is slightly higher than the RMS threshold voltage of a respective inner transistor, to the control layer (5) for generating a source side injection condition.

14. Method for erasing an information item in a nonvolatile semiconductor storage element according to one of Claims 1 to 4, comprising the following steps:
a) applying a floating potential to the source side interconnect layer (6BB);
b) applying a high first erase voltage to the drain side interconnect layer (6AA); and
c) applying a second erase voltage, which is lower than the RMS threshold voltage of a respective inner transistor, to the control layer (5) for generating an avalanche effect condition.

15. Method for reading an information item in a nonvolatile semiconductor storage element according to one of Claims 1 to 4, comprising the following steps:
a) applying a first positive read voltage to the source side interconnect layer (6BB);
b) applying a second read voltage, which is sufficiently smaller than the first read voltage, to the drain side interconnect layer (6AA); and
c) applying a third read voltage, which is in the region of the first read voltage, to the control layer (5) for generating a reverse readout.

## Revendications

1. Elément de mémoire non volatile à semi-conducteur comprenant
un substrat (1) semi-conducteur, dans lequel est formée une zone (S) de source, une zone (D) de drain et une zone de canal entre elles ;
une couche (5) de commande, qui est formée sur une première sous-partie (I) de la zone de canal et qui en est isolée par une couche (2A) isolante ;
une couche (3B) d'accumulation de charges côté source, qui est formée sur une deuxième sous-partie (IIB) côté source de la zone de canal et en est isolée par une deuxième couche (2BB) isolante côté source ;
une couche (3A) d'accumulation de charges côté drain, qui est formée sur une deuxième sous-partie (IIA) côté drain de la zone de canal et en est isolée par une deuxième couche (2BA) isolante côté drain ;
une couche (6B) de programmation côté source, qui est formée sur la couche (3B) d'accumulation de charges côté source et qui en est isolée par une troisième couche (4B) côté source ;
une couche (6A) de programmation côté drain, qui est formée sur la couche (3A) d'accumulation de charges côté drain et qui en est isolée par une troisième couche (4A) isolante côté drain ;
une couche (6BB) de liaison côté source, qui relie électriquement la couche (6B) de programmation côté source à la zone (S) de source ;
une couche (6AA) de liaison côté drain, qui relie électriquement la couche (6A) de programmation côté drain à la zone (D) de drain ;
**caractérisé en ce que** la couche (5) de commande, la couche (6A, 6B) de programmation et la couche (6AA, 6BB) de liaison comportent du polysilicium dopé.

2. Elément à semi-conducteur de mémoire non volatile suivant la revendication 1,
**caractérisé en ce que** la couche (3A, 3B) d'accumulation de charges constitue une couche non conductrice de l'électricité.

3. Elément à semi-conducteur de mémoire non volatile suivant l'une des revendications 1 ou 2,
**caractérisé en ce que** la première et la deuxième couches (2A, 2BA, 2BB) isolantes comportent du SiO₂.

4. Elément à semi-conducteur de mémoire non volatile suivant l'une des revendications 1 à 3,
**caractérisé en ce que** la couche (3A, 3B) d'accumulation de charges a une couche en Si₃N₄, en HFO₂ ou en ZrO₂.

5. Procédé de production d'un élément à semi-conducteur de mémoire non volatile comprenant les stades dans lesquels :
a) on prépare un substrat (1) semi-conducteur ;
b) on forme une première couche (2A) isolante à la surface du substrat (1) semi-conducteur ;
c) on forme et on structure une couche (5) de commande à la surface de la première couche (2A) isolante, la couche de commande comportant du polysilicium dopé ;
d) on forme une succession de couches constituée d'une deuxième couche (2B) isolante, d'une couche (3) d'accumulation de charges et d'une troisième couche (4) isolante à la surface du substrat (1) semi-conducteur et de la couche (5) de commande structurée ;
e) on forme et on structure une couche (6A, 6B) de programmation sur la troisième couche (4) isolante, sur les parois latérales de la couche (5) de commande structurée, la couche de programmation comportant du polysilicium dopée ;
f) on forme des zones (S) de source et des zones (D) de drain dans le substrat (1) semi-conducteur en utilisant la couche (6A, 6B) de programmation structurée et la couche (5) de commande structurée comme un masque ;
g) on structure la troisième couche (4), la couche (3) d'accumulation de charges et la deuxième couche (2B) isolante en utilisant la couche (6A, 6B) de programmation structurée comme masque ;
h) on forme une quatrième couche (7) isolante à la surface du substrat (1) semi-conducteur de la couche (6A, 6B) de programmation structurée et de la couche (5) de commande structurée ;
i) on met à nu des zones de liaison au moins sur des parties de la couche (6A, 6B) de programmation structurée de la zone (S) de source et de la zone (D) de drain ; et
j) on forme une couche (6AA, 6BB) de liaison conductrice de l'électricité dans les zones de liaison mises à nu pour la mise en contact de la couche (6A, 6B) de programmation de la zone (S) de source et de la zone (D) de drain, la couche de liaison comportant du polysilicium dopé.

6. Procédé suivant la revendication 5,
**caractérisé en ce que**, dans le stade b), on forme un diélectrique de grille sous la forme d'une première couche (2A) isolante.

7. Procédé suivant l'une des revendications 5 ou 6,
**caractérisé en ce que**, dans le stade d), on dépose une succession de couches ONO.

8. Procédé suivant l'une des revendications 5 à 7,
**caractérisé en ce que**, dans le stade e), on effectue un procédé avec espaceur pour le dépôt et la structuration de la couche (6A, 6B) de programmation.

9. Procédé suivant l'une des revendications 5 à 8,
**caractérisé en ce que**, dans le stade f), on effectue une implantation d'ions et un post-traitement thermique pour faire diffuser et activer les zones (S, D) de source et de drain.

10. Procédé suivant l'une des revendications 5 à 9,
**caractérisé en ce que**, dans le stade g), on effectue une attaque à sec anisotrope de la succession de couches et une attaque en retrait isotrope d'au moins la couche (3) d'accumulation de charges, pour former des évidements de la couche d'accumulation de charges.

11. Procédé suivant la revendication 10,
**caractérisé en ce que**, dans le stade h), on effectue un dépôt d'oxyde pour remplir les évidements de la couche d'accumulation de charges.

12. Procédé suivant l'une des revendications 5 à 11,
**caractérisé en ce que**, dans le stade j), on dépose et on planarise la couche (6AA, 6BB) de liaison.

13. Procédé pour écrire une information dans un élément à semi-conducteur de mémoire non volatile suivant l'une des revendications 1 à 4 comprenant les stades dans lesquels :
a) on applique une première tension positive d'écriture à la couche (6BB) de liaison côté source ;
b) on applique une deuxième tension positive d'écriture sensiblement plus haute que la première tension positive d'écriture à la couche (6AA) de liaison côté drain ; et
c) on applique à la couche (5) de commande une troisième tension positive d'écriture légèrement plus haute que la tension de seuil efficace d'un transistor intérieur respectif pour produire une condition d'injection côté source.

14. Procédé pour effacer une information dans un élément à semi-conducteur de mémoire relative suivant l'une des revendications 1 à 4 comprenant les stades dans lesquels :
a) on applique un potentiel flottant à la couche (6BB) de liaison côté source ;
b) on applique une première tension haute d'effacement à la couche (6AA) de liaison côté drain ; et
c) on applique à la couche (5) de commande une deuxième tension d'effacement plus basse que la tension de seuil efficace d'un transistor intérieur respectif pour produire une condition d'effet d'avalanche.

15. Procédé de lecture d'une information dans un élément à semi-conducteur de mémoire non volatile suivant l'une des revendications 1 à 4 comprenant les stades dans lesquels :
a) on applique un première tension positive de lecture à la couche (6BB) de liaison côté source ;
b) on applique une deuxième tension suffisamment plus basse que la première tension de lecture à la couche (6AA) de liaison côté drain ; et
c) on applique à la couche (5) de commande une troisième tension de lecture se trouvant dans la plage de la première tension de lecture, pour produire une condition de lecture en sens inverse.
